# EUROPEAN PATENT SPECIFICATION

(11) **EP 2 463 316 B1**
(45) Date of publication and mention of the grant of the patent: **08.06.2016**
(21) Application number: 10806355.3
(22) Date of filing: 26.07.2010
(51) Int. Cl.: C08F 220/02, C08F 220/10, C08F 220/26, C08F 290/02, G02B 1/04, H01L 23/29, H01L 23/31, C08F 220/18, C08F 220/68, C08F 222/10, H01L 31/0203, C08F 220/28, C08F 230/08, C08F 290/04

(54) **ACRYLATE COMPOSITION**
ACRYLATZUSAMMENSETZUNG
COMPOSITION D'ACRYLATE

(30) Priority: 04.08.2009 JP 2009181841
(43) Date of publication of application: 13.06.2012
(73) Proprietor: Idemitsu Kosan Co., Ltd., Chiyoda-ku Tokyo 100-8321 (JP)
(72) Inventor: IWASAKI, Takeshi, Ichihara-shi Chiba 299-0193 (JP); OGAWA, Daichi, Ichihara-shi Chiba 299-0193 (JP); OBATA, Yutaka, Ichihara-shi Chiba 299-0193 (JP); TAKEBE, Tomoaki, Ichihara-shi Chiba 299-0193 (JP)
(74) Representative: Vossius & Partner Patentanwälte Rechtsanwälte mbB
(86) International application number: PCT/JP2010/062551
(87) International publication number: WO 2011/016356

(56) References cited:
- WO-A1-2006/051803
- WO-A1-2009/005036
- DE-T5-112007 001 060
- JP-A- 2001 131 215
- JP-A- 2002 080 548
- JP-A- 2008 127 503
- JP-A- 2008 127 503
- US-A- 4 703 338
- US-A1- 2008 097 072

## Description

### Technical Field

The present invention relates to a composition containing an acrylate compound. More particularly, the present invention relates to a composition which is suitably employed as a raw material for, for example, an encapsulating material or a lens; and to a cured product of the composition.

### Background Art

A wide variety of display apparatuses or instruments employ a photo-semiconductor device (semiconductor light-emitting device) incorporating, as a light-emitting element, an LED (light-emitting diode) chip including a light-emitting layer having a p-n junction formed of semiconductor layers grown on a crystalline substrate.

Such a photo-semiconductor device is, for example, a high-temperature-operating electronic device or a visible-light-emitting device employing a gallium nitride compound semiconductor (e.g., GaN, GaAlN, InGaN, or InAlGaN). Recently, such a device has been developed in the fields of blue light-emitting diodes and UV light-emitting diodes.

In a photo-semiconductor device incorporating an LED chip as a light-emitting element, the LED chip is mounted on a lead frame on the side of a light-emitting surface; the LED chip and the lead frame are electrically connected through wire bonding; and the light-emitting element is encapsulated with a resin which serves to protect the element and also functions as a lens.

In recent years, white LEDs have become of interest as a new light source. It is expected that white LEDs will be increasingly spread in the market, mainly for illumination applications. White LEDs which have been put into practice include a type in which a YAG phosphor is applied to a GaN bare chip, and white light is emitted by mixing blue light from the GaN chip with yellow light from the phosphor; and a type in which white light is emitted from a single package including three chips (i.e., red, green, and blue light-emitting chips). In recent years, there has also been developed a technique in which a UV LED chip serving as a light source is used in combination with a plurality of phosphor materials, from the viewpoint of improvement of color tone. In order to use an LED for illumination applications, etc., the LED is required to exhibit improved durability.

In many cases, epoxy resin is used as a material for encapsulating a light-emitting element such as an LED (light-emitting diode) chip, since, for example, epoxy resin exhibits transparency and favorable processability. Generally, most epoxy resins used for LED encapsulating are formed of bisphenol A glycidyl ether, methylhexahydrophthalic anhydride, and a curing accelerator (e.g., an amine or phosphorus-containing curing accelerator). However, such an epoxy resin poses a problem in that it turns yellow by absorbing visible light, since the components of the resin generate a carbonyl group through absorption of UV light. In order to solve such a problem, an epoxy resin employing hydrogenated bisphenol A glycidyl ether (Non-Patent Document 1) has been proposed, but the epoxy resin may fail to exhibit satisfactory performance.

From the viewpoint of suppression of yellowing or brightness reduction caused by UV light, silicone resin is widely employed. Silicone resin exhibits excellent transparency in a UV region, and is much less likely to undergo yellowing or reduction in transmittance due to UV light. However, silicone resin poses problems in terms of low light extraction performance due to low refractive index of the resin, as well as poor adhesion between the resin and a lead frame or a reflector due to low polarity of the resin.

For production of a surface mount type LED, reflow soldering is carried out. Since the LED is exposed to heat of 260°C for about 10 seconds in a reflow furnace, when a conventional epoxy resin or silicone resin is employed for the LED, deformation or cracking may occur under heating.

Patent Document 1 discloses that a polymer exhibiting excellent optical properties, heat resistance, and water resistance is produced through homopolymerization or copolymerization of an alicyclic acrylic acid ester or methacrylic acid ester having 10 or more carbon atoms. This patent document describes that the polymer is used as an encapsulating material for light-emitting diodes. However, the polymer is required to be further improved in terms of, for example, adhesion.

Patent Document 2 describes, for example, a transparent encapsulating material for photo-semiconductors which exhibits stability against UV rays or heat, is less likely to turn yellow, and provides a cured product exhibiting excellent adhesion. However, a cured product of the encapsulating material may exhibit poor adhesion to a base member surrounding the product (e.g., a resin serving as a reflective material, or a metallic frame), and thus the encapsulating material requires further technological development.

### Prior Art Document

### Patent Document

Patent Document 1: Japanese Patent Application Laid-Open (*kokai*) No. H02-67248
Patent Document 2: International Publication pamphlet WO 2007/129536 or DE 11 2007 001 060T5
Patent Document 3: US 2008/097072 A2
Patent Document 4: JP 2008 127503 A

### Non-Patent Document

Non-Patent Document 1: NEDO "Light for the 21st Century: The Development of Compound Semiconductors for High Efficiency Optoelectronic Conversion, Report of Results (2001)"

### Disclosure of the Invention

### Problems to be Solved by the Invention

In view of the foregoing, an object of the present invention is to provide a composition which is suitably employed as a raw material for, for example, an encapsulating material or a lens, which exhibits transparency and heat resistance comparable to conventional levels, and which provides a cured product exhibiting excellent adhesion to a base member around the cured product.

### Means for Solving the Problems

The present inventors have conducted extensive studies, and as a result have found that the aforementioned problems can be solved by a composition containing a specific acrylate compound. The present invention has been accomplished on the basis of this finding.

Accordingly, the present invention provides:
1. a composition characterized by comprising the following components (A) to (D):
   (A) one or more (meth)acrylate compounds selected from among a (meth)acryl-modified silicone fluid, a long-chain alkyl (meth)acrylate, and a polyalkylene glycol (meth)acrylate having a number average molecular weight of 400 or more;
   (B) a (meth)acrylate compound having an alicyclic hydrocarbon group which has six or more carbon atoms and which is bonded to the compound via an ester bond;
   (C) (meth)acrylic acid or a (meth)acrylate compound having a polar group; and
   (D) a radical polymerization initiator;
2. a composition according to 1 above, wherein component (A) is a long-chain alkyl (meth)acrylate selected from among (meth)acrylates each having an alkyl group having 12 or more carbon atoms, and/or a polyalkylene glycol (meth)acrylate having a number average molecular weight of 400 or more;
3. a composition according to 1 or 2 above, wherein component (A) is a long-chain alkyl (meth)acrylate selected from among hydrogenated polybutadiene di(meth)acrylates and hydrogenated polyisoprene di(meth)acrylates, and/or a polyethylene glycol di(meth)acrylate having a number average molecular weight of 400 or more;
4. a composition according to any of 1 to 3 above, wherein component (B) is a (meth)acrylate compound having one or more alicyclic hydrocarbon groups selected from among an adamantyl group, a norbornyl group, an isobornyl group, a dicyclopentanyl group, and a cyclohexyl group, the alicyclic hydrocarbon groups being bonded to the compound via an ester bond;
5. a composition according to any of 1 to 4 above, wherein component (C) is a (meth)acrylate compound having a polar group selected from among a hydroxyl group, an epoxy group, a glycidyl ether group, a tetrahydrofurfuryl group, an isocyanate group, a carboxyl group, an alkoxysilyl group, a phosphoric acid ester group, a lactone group, an oxetane group, and a tetrahydropyranyl group;
6. a composition according to any of 1 to 5 above, wherein the amounts of component (A), component (B), and component (C) are 10 to 90 mass%, 5 to 90 mass%, and 0.5 to 50 mass%, respectively, on the basis of the total amount of components (A), (B), and (C), and the amount of component (D) is 0.01 to 10 parts by mass on the basis of 100 parts by mass of the total amount of components (A), (B), and (C);
7. a cured product produced through curing of a composition as recited in any of 1 to 6 above;
8. an encapsulating material comprising a cured product as recited in 7 above;
9. an encapsulating material according to 8 above, which is employed for a photo-semiconductor or a photoreceptor;
10. a lens produced from a cured product as recited in 7 above; and
11. a lens according to 10 above, which is employed in the semiconductor field or the optical field.

### Effects of the Invention

According to the present invention, there is provided a composition which is suitably employed as a raw material for, for example, an encapsulating material or a lens, which exhibits excellent transparency and heat resistance, and which provides a cured product exhibiting excellent adhesion to a base member surrounding the product (e.g., a resin serving as a reflective material, or a metallic frame). Best Modes for Carrying Out the Invention

The composition of the present invention contains the following components (A) to (D): (A) one or more (meth)acrylate compounds selected from among a (meth)acryl-modified silicone fluid, a long-chain alkyl (meth)acrylate, and a polyalkylene glycol (meth)acrylate having a number average molecular weight of 400 or more; (B) a (meth)acrylate compound having an alicyclic hydrocarbon group which has six or more carbon atoms and which is bonded to the compound via an ester bond; (C) (meth)acrylic acid or a (meth)acrylate compound having a polar group; and (D) a radical polymerization initiator.

The (meth)acryl-modified silicone fluid serving as component (A) is a compound having a dialkylpolysiloxane skeleton with an acrylic group and/or methacrylic group at an end thereof. Generally, the (meth)acryl-modified silicone fluid serving as component (A) is a modified product of dimethylpolysiloxane. However, all the alkyl groups or a portion of the alkyl groups in the dialkylpolysiloxane skeleton may be substituted by a phenyl group (in place of a methyl group) or an alkyl group other than a methyl group. Examples of the alkyl group other than a methyl group include an ethyl group and a propyl group. Specific examples of the silicon oil include X-24-8201, X-22-174DX, X-22-2426, X-22-2404, X-22-164A, and X-22-164C (products of Shin-Etsu Chemical Co., Ltd.), and BY16-152D, BY16-152, and BY16-152C (products of Dow Corning Toray Co., Ltd.).

The (meth)acryl-modified silicone fluid serving as component (A) may be a polydialkylsiloxane having an acryloxyalkyl or a methacryloxyalkyl group at an end thereof. Specific examples include methacryloxypropyl-end-blocked polydimethylsiloxane, (3-acryloxy-2-hydroxypropyl)-end-blocked polydimethylsiloxane, acryloxy-end-blocked ethylene oxide-dimethylsiloxane-ethylene oxide-ABA block copolymer, and methacryloxypropyl-end-blocked branched polydimethylsiloxane.

Of these, (3-acryloxy-2-hydroxypropyl)-end-blocked polydimethylsiloxane or acryloxy-end-blocked ethylene oxide-dimethylsiloxane-ethylene oxide-ABA block copolymer is preferably employed, from the viewpoint of transparency after curing.

The long-chain alkyl (meth)acrylate serving as component (A) is a (meth)acrylate having a long-chain alkyl group. Examples of the long-chain alkyl group include alkyl groups having 12 or more carbon atoms. Specific examples include a dodecyl group, a lauryl group, a tetradecyl group, a hexadecyl group, an octadecyl group (including a stearyl group), an eicosyl group, a triacontyl group, and a tetracontyl group. The alkyl group having 12 or more carbon atoms may be an alkyl group derived from a hydrogenated product of a polymer such as polybutadiene or polyisoprene. When a (meth)acrylate having an alkyl group having 12 or more carbon atoms is employed, excellent adhesion is achieved.

Specific examples of the long-chain alkyl (meth)acrylate include acrylic or methacrylic compounds having a hydrogenated polybutadiene or hydrogenated polyisoprene skeleton, such as hydrogenated polybutadiene di(meth)acrylate and hydrogenated polyisoprene di(meth)acrylate; and stearyl methacrylate.

Of these, hydrogenated polybutadiene di(meth)acrylate or hydrogenated polyisoprene di(meth)acrylate is preferably employed, from the viewpoint of adhesion.

Examples of the polyalkylene glycol (meth)acrylate having a number average molecular weight of 400 or more, serving as component (A), include polyethylene glycol di(meth)acrylate, polypropylene glycol di(meth)acrylate, polybutylene glycol di(meth)acrylate, ethoxylated trimethylolpropane tri(meth)acrylate, and ethoxylated pentaerythritol tetra(meth)acrylate. When a polyalkylene glycol (meth)acrylate having a number average molecular weight of 400 or more is employed, excellent toughness and adhesion are achieved. No particular limitation is imposed on the maximum of the number average molecular weight. However, a polyalkylene glycol (meth)acrylate having a number average molecular weight of 10,000 or less is preferably employed, from the viewpoint of compatibility of the (meth)acrylate with component (B).

In the present invention, component (A) may be at least one species selected from among the aforementioned (meth)acryl-modified silicone fluids, at least one species selected from among the aforementioned long-chain alkyl (meth)acrylates, or at least one species selected from among the aforementioned polyalkylene glycol (meth)acrylates having a number average molecular weight of 400 or more. Alternatively, component (A) may be an appropriate combination of species selected from among the aforementioned (meth)acryl-modified silicone fluids, the aforementioned long-chain alkyl (meth)acrylates, and the aforementioned polyalkylene glycol (meth)acrylates having a number average molecular weight of 400 or more.

In the composition of the present invention, the amount of component (A) is generally 10 to 90 mass%, preferably 15 to 80 mass%, on the basis of the total amount of components (A), (B), and (C). When the amount of component (A) is 10 mass% or more, excellent adhesion and toughness are achieved.

Component (B) is a (meth)acrylate compound having an alicyclic hydrocarbon group which has six or more carbon atoms and which is bonded to the compound via an ester bond. Examples of the alicyclic hydrocarbon group include a cyclohexyl group, a 2-decahydronaphthyl group, an adamantyl group, a 1-methyladamantyl group, a 2-methyladamantyl group, a biadamantyl group, a dimethyladamantyl group, a norbornyl group, a 1-methyl-norbornyl group, a 5,6-dimethyl-norbornyl group, an isobornyl group, a tetracyclo[4.4.0.12,5.17,10]dodecyl group, a 9-methyl-tetracyclo[4.4.0.12,5.17,10]dodecyl group, a bornyl group, and a dicyclopentanyl group. Of these, a cyclohexyl group, an adamantyl group, a norbornyl group, an isobornyl group, or a dicyclopentanyl group is preferred, from the viewpoint of heat resistance. An adamantyl group is more preferred, and a 1-adamantyl group is particularly preferred.

Examples of the (meth)acrylate compound serving as component (B) include (meth)acrylates having the aforementioned alicyclic hydrocarbon groups, such as cyclohexyl acrylate, cyclohexyl methacrylate, 1-adamantyl (meth)acrylate, norbornyl (meth)acrylate, isobornyl (meth)acrylate, and dicyclopentanyl (meth)acrylate. In the present invention, the aforementioned (meth)acrylate compounds serving as component (B) may be employed singly or in combination of two or more species.

In the present invention, when a (meth)acrylate compound having an alicyclic hydrocarbon group having six or more carbon atoms is employed, excellent heat resistance is achieved. Since the ester substituent is an alicyclic hydrocarbon group and does not contain an aromatic group, etc., the composition is less likely to be impaired by UV rays.

In the composition of the present invention, the amount of component (B) is generally 5 to 90 mass%, preferably 10 to 80 mass%, on the basis of the total amount of components (A), (B), and (C). When the amount of component (B) is 5 mass% or more, excellent rigidity, heat resistance, and transparency are achieved.

Component (C) employed is acrylic acid, methacrylic acid, or a (meth)acrylate compound having a polar group. Since component (C) has polarity, component (C) forms a hydrogen bond, etc. with, for example, the surface of a metal having polarity as in the case of component (C), whereby adhesion is improved. Also, wettability is improved by virtue of the presence of such a polar group. Although an alkylene glycol group may be responsible for imparting adhesion, an alkylene glycol (meth)acrylate is not included in component (C). Examples of the (meth)acrylate compound having a polar group include a (meth)acrylate compound having a substituent which contains an atom other than carbon and hydrogen and which is bonded to the compound via an ester bond. Examples of the substituent include a hydroxyl group, an epoxy group, a glycidyl ether group, a tetrahydrofurfuryl group, an isocyanate group, a carboxyl group, an alkoxysilyl group, a phosphoric acid ester group, a lactone group, an oxetane group, a tetrahydropyranyl group, and an amino group. Specific examples of the (meth)acrylate compound having a polar group include 2-hydroxyethyl (meth)acrylate, 2-hydroxypropyl (meth)acrylate, 2-hydroxybutyl (meth)acrylate, 4-hydroxybutyl (meth)acrylate (4-HBA (trade name), product of Nippon Kasei Chemical Co., Ltd.), cyclohexanedimethanol mono(meth)acrylate (CHMMA (trade name), product of Nippon Kasei Chemical Co., Ltd.), glycidyl (meth)acrylate, 4-hydroxybutyl acrylate glycidyl ether (4-HBAGE (trade name), product of Nippon Kasei Chemical Co., Ltd.), tetrahydrofurfuryl (meth)acrylate, 2-isocyanatoethyl (meth)acrylate, 2-(meth)acryloyloxyethylsuccinic acid, 2-(meth)acryloyloxyethylhexahydrophthalic acid, 3-(meth)acryloxypropyltrimethoxysilane, 3-(meth)acryloxypropylmethyldimethoxysilane, 3-(meth)acryloxypropyltriethoxysilane, 3-(meth)acryloxypropylmethyldiethoxysilane, 2-(meth)acryloyloxyethyl phosphate, di(2-(meth)acryloyloxyethyl) phosphate, KAYAMER PM-21 (product of Nippon Kayaku Co., Ltd.), γ-butyrolactone (meth)acrylate, (3-methyl-3-oxetanyl) (meth)acrylate, (3-ethyl-3-oxetanyl) (meth)acrylate, tetrahydrofurfuryl (meth)acrylate, dimethylaminoethyl (meth)acrylate, and diethylaminoethyl (meth)acrylate.

In the present invention, component (C) may be at least one species selected from among the aforementioned (meth)acrylic acids, or at least one species selected from among the aforementioned (meth)acrylate compounds having a polar group. Alternatively, component (C) may be an appropriate combination of species selected from among the aforementioned (meth)acrylic acids, and the aforementioned (meth)acrylate compounds having a polar group.

In the composition of the present invention, the amount of component (C) is generally 0.5 to 50 mass%, preferably 1 to 40 mass%, on the basis of the total amount of components (A), (B), and (C). In the case where the amount of component (C) is 0.5 mass% or more, when, for example, an encapsulating material containing the composition is employed for encapsulating of a photo-semiconductor, the encapsulating material exhibits excellent adhesion to a resin material or a metal material which comes into contact with the encapsulating material.

Examples of the radical polymerization initiator serving as component (D) include ketone peroxides such as methyl ethyl ketone peroxide, methyl isobutyl ketone peroxide, acetylacetone peroxide, cyclohexanone peroxide, and methylcyclohexanone peroxide; hydroperoxides such as 1,1,3,3-tetramethylbutyl hydroperoxide, cumene hydroperoxide, and t-butyl hydroperoxide; diacyl peroxides such as diisobutyryl peroxide, bis-3,5,5-trimethylhexanol peroxide, lauroyl peroxide, benzoyl peroxide, and m-toluyl benzoyl peroxide; dialkyl peroxides such as dicumyl peroxide, 2,5-dimethyl-2,5-di(t-butylperoxy)hexane, 1,3-bis(t-butylperoxyisopropyl)hexane, t-butylcumyl peroxide, di-t-butyl peroxide, and 2,5-dimethyl-2,5-di(t-butylperoxy)hexene; peroxyketals such as 1,1-di(t-butylperoxy-3,5,5-trimethyl)cyclohexane, 1,1-di-t-butylperoxycyclohexane, and 2,2-di(t-butylperoxy)butane; alkyl peresters such as 1,1,3,3-tetramethylbutyl peroxyneodicarbonate, α-cumyl peroxyneodicarbonate, t-butyl peroxyneodicarbonate, t-hexyl peroxypivalate, t-butyl peroxypivalate, 1,1,3,3-tetramethylbutyl peroxy-2-ethylhexanoate, t-amyl peroxy-2-ethylhexanoate, t-butyl peroxy-2-ethylhexanoate, t-butyl peroxyisobutyrate, di-t-butyl peroxyhexahydroterephthalate, 1,1,3,3-tetramethylbutyl peroxy-3,5,5-trimethylhexanoate, t-amyl peroxy-3,5,5-trimethylhexanoate, t-butyl peroxy-3,5,5-trimethylhexanoate, t-butyl peroxyacetate, t-butyl peroxybenzoate, and dibutyl peroxytrimethyladipate; and peroxycarbonates such as di-3-methoxybutyl peroxydicarbonate, di-2-ethylhexyl peroxydicarbonate, bis(1,1-butylcyclohexaoxy dicarbonate), diisopropyloxy dicarbonate, t-amyl peroxyisopropyl carbonate, t-butyl peroxyisopropyl carbonate, t-butyl peroxy-2-ethylhexyl carbonate, and 1,6-bis(t-butyl peroxycarboxy)hexane.

Component (D) may be a photo-radical polymerization initiator. Examples of the photo-radical polymerization initiator include Irgacure 651 (trademark, product of Ciba Specialty Chemicals), Irgacure 184 (trademark, product of Ciba Specialty Chemicals), DAROCUR 1173 (trademark, product of Ciba Specialty Chemicals), Irgacure 2959 (trademark, product of Ciba Specialty Chemicals), Irgacure 127 (trademark, product of Ciba Specialty Chemicals), Irgacure 907 (trademark, product of Ciba Specialty Chemicals), Irgacure 369 (trademark, product of Ciba Specialty Chemicals), Irgacure 379 (trademark, product of Ciba Specialty Chemicals), DAROCUR TPO (trademark, product of Ciba Specialty Chemicals), Irgacure 819 (trademark, product of Ciba Specialty Chemicals), and Irgacure 784 (trademark, product of Ciba Specialty Chemicals).

The radical polymerization initiators serving as component (D) may be employed singly or in combination of a plurality of species. The amount of component (D) employed is generally 0.01 to 10 parts by mass, preferably 0.1 to 5.0 parts by mass, on the basis of 100 parts by mass of the total amount of components (A), (B), and (C).

The composition of the present invention may contain, in addition to components (A) to (D), inorganic particles or a phosphor serving as component (E). The inorganic particles employed may be any type of particles. Specific examples of the inorganic particles include particles of quartz, silicic anhydride, silica (e.g., fused silica or crystalline silica), alumina, zirconia, and titanium oxide. Other examples of the inorganic particles include inorganic particles which have been employed or proposed as a filler for a conventional encapsulating material (e.g., epoxy resin). Such inorganic particles may be appropriately subjected to a surface treatment, such as alkylation treatment, trimethylsilylation treatment, silicone treatment, or treatment with a coupling agent.

The phosphor for a white LED may be, for example, a YAG phosphor or a silicate phosphor.

Component (E) may be a single type of inorganic particles or phosphor. Alternatively, a plurality of compounds may be employed in combination as component (E). The amount of component (E) employed is generally 1 to 100 parts by mass, preferably 10 to 50 parts by mass, on the basis of 100 parts by mass of the total amount of components (A), (B), and (C).

The composition of the present invention may contain one or more other (meth)acrylate compounds [i.e., (meth)acrylate compound(s) other than components (A) to (C)] as component (F) for imparting strength. Examples of the (meth)acrylate compound(s) serving as component (F) include ethylene glycol di(meth)acrylate, propylene glycol di(meth)acrylate, 1,4-butanediol (meth)acrylate, 1,6-hexanediol di(meth)acrylate, 1,9-nonanediol di(meth)acrylate, neopentyldiol di(meth)acrylate, polyethylene glycol di(meth)acrylate or polypropylene glycol di(meth)acrylate having a number average molecular weight of less than 400, alkoxypolyalkylene glycol (meth)acrylate such as methoxypolyethylene methacrylate, ethylene oxide-modified bisphenol A di(meth)acrylate, propylene oxide-modified bisphenol A di(meth)acrylate, epichlorohydrin-modified bisphenol A di(meth)acrylate, propylene oxide-modified glycerin tri(meth)acrylate, trimethylolpropane tri(meth)acrylate, ditrimethylolpropane tetra(meth)acrylate, dipentaerythritol hexa(meth)acrylate, tris(acryloyloxyethyl) isocyanurate, and methoxypolyethylene glycol (meth)acrylate.

The (meth)acrylate compounds serving as component (F) may be employed singly or in combination of a plurality of species. The amount of component (F) contained in the composition is generally 100 parts by mass or less, preferably 50 parts by mass or less, on the basis of 100 parts by mass of the total amount of components (A), (B), and (C).

The composition of the present invention may further contain, for example, a known antioxidant or light stabilizer. Examples of the antioxidant include a phenolic antioxidant, a phosphorus-containing antioxidant, a sulfur-containing antioxidant, a vitamin antioxidant, a lactone antioxidant, and an amine antioxidant.

Examples of the phenolic antioxidant include commercially available products such as Irganox 1010 (trademark, product of Ciba Specialty Chemicals), Irganox 1076 (trademark, product of Ciba Specialty Chemicals), Irganox 1330 (trademark, product of Ciba Specialty Chemicals), Irganox 3114 (trademark, product of Ciba Specialty Chemicals), Irganox 3125 (trademark, product of Ciba Specialty Chemicals), Irganox 3790 (trademark, product of Ciba Specialty Chemicals) BHT, Cyanox 1790 (trademark, product of Cyanamid Co.), and Sumilizer GA-80 (trademark, product of Sumitomo Chemical Co., Ltd.).

Examples of the phosphorus-containing antioxidant include commercially available products such as Irgafos 168 (trademark, product of Ciba Specialty Chemicals), Irgafos 12 (trademark, product of Ciba Specialty Chemicals), Irgafos 38 (trademark, product of Ciba Specialty Chemicals), ADKSTAB 329K (trademark, product of ADEKA Corporation), ADKSTAB PEP36 (trademark, product of ADEKA Corporation), ADKSTAB PEP-8 (trademark, product of ADEKA Corporation), Sardstab P-EPQ (trademark, product of Clariant), Weston 618 (trademark, product of GE), Weston 619G (trademark, product of GE), and Weston-624 (trademark, product of GE).

Examples of the sulfur-containing antioxidant include commercially available products such as DSTP (Yoshitomi) (trademark, product of Yoshitomi), DLTP (Yoshitomi) (trademark, product of Yoshitomi), DLTOIB (trademark, product of Yoshitomi), DMTP (Yoshitomi) (trademark, product of Yoshitomi), Seenox 412S (trademark, product of Shipro Kasei Kaisha, Ltd.), Cyanox 1212 (trademark, product of Cyanamid Co.), and Sumilizer TP-D (trademark, product of Sumitomo Chemical Co., Ltd.).

Examples of the vitamin antioxidant include commercially available products such as tocopherol and Irganox E201 (trademark, product of Ciba Specialty Chemicals, compound name: 2,5,7,8-tetramethyl-2(4',8',12'-trimethyltridecyl)coumaron-6-ol).

Examples of the lactone antioxidant which may be employed include compounds described in Japanese Patent Application Laid-Open (*kokai*) Nos. H07-233160 and H07-247278. Other examples of the lactone antioxidant include HP-136 (trademark, product of Ciba Specialty Chemicals, compound name: 5,7-di-t-butyl-3-(3,4-dimethylphenyl)-3H-benzofuran-2-one).

Examples of the amine antioxidant include commercially available products such as Irgastab FS042 (trademark, product of Ciba Specialty Chemicals) and GENOX EP (trademark, product of Crompton Corporation, compound name: dialkyl-N-methylamine oxide).

These compounds (antioxidants) may be employed singly or in combination of a plurality of species. The amount of the antioxidant contained in the composition is generally 0.005 to 5 parts by mass, preferably 0.02 to 2 parts by mass, on the basis of 100 parts by mass of the total amount of components (A), (B), and (C).

The light stabilizer employed may be a generally known one, but is preferably a hindered amine light stabilizer. Specific examples include ADK STAB LA-52, LA-57, LA-62, LA-63, LA-67, LA-68, LA-77, LA-82, LA-87, and LA-94 (trade names, products of ADEKA Corporation), Tinuvin 123, 144, 440, and 662 and Chimassorb 2020, 119, and 944 (trade names, products of CSC), Hostavin N30 (trade name, product of Hoechst), Cyasorb UV-3346 and UV-3526 (trade names, products of Cytec), Uval 299 (trade name, product of GLC), and Sanduvor PR-31 (trade name, product of Clariant).

These compounds (light stabilizers) may be employed singly or in combination of a plurality of species. The amount of the light stabilizer contained in the composition is generally 0.005 to 5 parts by mass, preferably 0.002 to 2 parts by mass, on the basis of 100 parts by mass of the total amount of components (A), (B), and (C).

The composition of the present invention produces a cured product through thermal treatment at a temperature equal to or higher than the temperature at which radicals are generated from component (D) (or through light irradiation in the case where component (D) is a photo-radical polymerization initiator). Curing conditions may be appropriately determined in consideration of the decomposition characteristics of the initiator employed.

A cured product produced through curing of the composition of the present invention is preferably employed as an encapsulating material or a lens material.

Examples of the encapsulating material include a encapsulating material for a photo-semiconductor and a encapsulating material for a photoreceptor. Examples of elements which are encapsulated with the encapsulating material include light-emitting diode (LED) chip, semiconductor laser, photodiode, photointerrupter, photocoupler, phototransistor, electroluminescence element, CCD, and solar cell.

Examples of the lens include a lens employed in the semiconductor field and a lens employed in the optical field. Examples

The present invention will next be described in more detail by way of examples, which should not be construed as limiting the invention thereto.

The physical properties of cured products produced in the Examples and the Comparative Examples were evaluated through the below-described methods. Number average molecular weight was determined through NMR.

### (1) Total light transmittance

A test piece (thickness: 3 mm) was employed as a sample, and the total light transmittance of the test piece was measured according to JIS K7105 by means of a measurement apparatus HGM-2DP (product of Suga Test Instruments Co., Ltd.). Specifically, the test piece was placed in a thermostatic chamber at 140°C for 100 hours, and the total light transmittances of the test piece were measured before and after the 100-hour treatment.

### (2) Adhesion test

Adhesion test was carried out by simulating encapsulating of a photo-semiconductor. Specifically, the adhesion of an encapsulating resin to a resin serving as a reflective material (polyamide resin) or to a lead frame metal was evaluated as follow.

The following test pieces were employed: a test piece formed by stacking two plates (width: 25 mm, length: 100 mm, thickness: 2 mm) made of polyphthalamide resin (AMODEL A-4122 NL, product of Solvay Advanced Polymers K.K.) so as to overlap with each other by 1.25 cm, and applying, to the overlapped portion, a composition produced in each of the Examples and the Comparative Examples, followed by curing; and a test piece formed by stacking two silver-plated metal plates (width: 10 mm, length: 75 mm, thickness: 0.15 mm) so as to overlap with each other by 2 cm, and applying the composition to the overlapped portion, followed by curing. The adhesion test was carried out according to JIS K6850 by means of Autograph AG-10 (tensile tester with thermostatic chamber, product of Shimadzu Corporation) serving as a measuring apparatus under the following conditions: measurement temperature: 23°C, humidity: 50%, tensile speed: 20 mm/minute, tensile load: load cell 10 kN.

### Example 1

A composition was produced by mixing the following components (A) to (D) together: component (A): hydrogenated polybutadiene diacrylate (SPBDA-S30 (trade name), product of Osaka Organic Chemical Industry Ltd.) serving as [long-chain alkyl (meth)acrylate] (5 g); component (B): 1-adamantyl methacrylate (Adamantate M-104 (trade name), product of Idemitsu Kosan Co., Ltd.) (5 g); component (C): 2-hydroxyethyl methacrylate (product of Tokyo Chemical Industry Co., Ltd.) (0.5 g); and component (D): 1,1-bis(t-hexylperoxy)cyclohexane (Perhexa HC (trade name), product of NOF Corporation) (0.1 g).

The composition was added to a cell formed by sandwiching a Teflon (registered trademark) spacer (thickness: 3 mm) between two steel plates and by sandwiching an aluminum plate (thickness: 0.3 mm) between one of the steel plates and the spacer, and the cell was heated in an oven at 110°C for three hours and then at 160°C for one hour, followed by cooling to room temperature, to thereby produce a colorless, transparent plate-like cured product having a thickness of 3 mm. A test piece employed for the adhesion test was formed through curing under the same conditions as described above. Table 1 shows the evaluation results of the thus-produced cured product.

### Example 2

The procedure of Example 1 was repeated, except that methacrylic acid (product of Wako Pure Chemical Industries, Ltd.) was employed as component (C), to thereby produce a composition and a cured product. Table 1 shows the evaluation results of the thus-produced cured product.

### Example 3

The procedure of Example 1 was repeated, except that glycidyl methacrylate (product of Wako Pure Chemical Industries, Ltd.) was employed as component (C), to thereby produce a composition and a cured product. Table 1 shows the evaluation results of the thus-produced cured product.

### Example 4

The procedure of Example 1 was repeated, except that 2-isocyanatoethyl methacrylate (Karenz MOI (trade name), product of Showa Denko K.K.) was employed as component (C), to thereby produce a composition and a cured product. Table 1 shows the evaluation results of the thus-produced cured product.

### Example 5

The procedure of Example 1 was repeated, except that 3-methacryloxypropyltrimethoxysilane (KBM-503 (trade name), product of Shin-Etsu Chemical Co., Ltd.) was employed as component (C), to thereby produce a composition and a cured product. Table 1 shows the evaluation results of the thus-produced cured product.

### Example 6

The procedure of Example 1 was repeated, except that tetrahydrofurfuryl methacrylate (SR203 (trade name), product of Sartomer) was employed as component (C), to thereby produce a composition and a cured product. Table 1 shows the evaluation results of the thus-produced cured product.

### Example 7

The procedure of Example 1 was repeated, except that KAYAMER PM-21 (trade name, product of Nippon Kayaku Co., Ltd., methacrylate having a phosphoric acid ester structure) (0.1 g) was employed as component (C), to thereby produce a composition and a cured product. Table 1 shows the evaluation results of the thus-produced cured product.

### Example 8

The procedure of Example 3 was repeated, except that hydrogenated polyisoprene diacrylate (SPIDA (trade name), product of Osaka Organic Chemical Industry Ltd.) was employed as component (A), to thereby produce a composition and a cured product. Table 1 shows the evaluation results of the thus-produced cured product.

### Example 9

The procedure of Example 5 was repeated, except that hydrogenated polyisoprene diacrylate (SPIDA (trade name), product of Osaka Organic Chemical Industry Ltd.) was employed as component (A), to thereby produce a composition and a cured product. Table 1 shows the evaluation results of the thus-produced cured product.

### Comparative Example 1

The procedure of Example 1 was repeated, except that component (C) was not employed, to thereby produce a composition and a cured product. Table 1 shows the evaluation results of the thus-produced cured product.

[Table 1]

**Table 1**

| | | Example | | | | | | | | | Comparative Example |
|---|---|---|---|---|---|---|---|---|---|---|---|
| | | 1 | 2 | 3 | 4 | 5 | 6 | 7 | 8 | 9 | 1 |
| Total light transmittance (%) | Initial | 86 | 75 | 89 | 90 | 89 | 90 | 90 | 86 | 85 | 88 |
| | After heating at 140°C for 100 hrs | 86 | 75 | 88 | 86 | 88 | 88 | 86 | 85 | 85 | 87 |
| Adhesion test Maximum point stress (MPa) | Polyamide resin | 1.0 | 1.8 | 3.6 | 2.9 | 1.2 | 1.0 | 2.4 | 3.5 | 1.3 | 0.5 |
| | Silver**-**plated metal plate | 3.3 | 3.4 | 3.5 | 3.3 | 3.2 | 3.5 | 3.4 | 3.4 | 3.3 | 2.9 |

### Example 10

A composition was produced by mixing the following components (A) to (D) together: component (A): polyethylene glycol #400 dimethacrylate (NK Ester 9G (trade name), product of Shin-Nakamura Chemical Co., Ltd.) serving as [polyalkylene glycol (meth)acrylate having a number average molecular weight of 400 or more] (5 g); component (B): 1-adamantyl methacrylate (Adamantate M-104 (trade name), product of Idemitsu Kosan Co., Ltd.) (5 g); component (C): 2-hydroxyethyl methacrylate (product of Tokyo Chemical Industry Co., Ltd.) (0.5 g); and component (D): 1,1-bis(t-hexylperoxy)cyclohexane (Perhexa HC (trade name), product of NOF Corporation) (0.1 g).

The composition was added to a cell formed by sandwiching a Teflon (registered trademark) spacer (thickness: 3 mm) between two steel plates and by sandwiching an aluminum plate (thickness: 0.3 mm) between one of the steel plates and the spacer, and the cell was heated in an oven at 110°C for three hours and then at 160°C for one hour, followed by cooling to room temperature, to thereby produce a colorless, transparent plate-like cured product having a thickness of 3 mm. A test piece employed for the adhesion test was formed through curing under the same conditions as described above. Table 2 shows the evaluation results of the thus-produced cured product.

### Example 11

The procedure of Example 10 was repeated, except that methacrylic acid (product of Wako Pure Chemical Industries, Ltd.) was employed as component (C), to thereby produce a composition and a cured product. Table 2 shows the evaluation results of the thus-produced cured product.

### Example 12

The procedure of Example 10 was repeated, except that glycidyl methacrylate (product of Wako Pure Chemical Industries, Ltd.) was employed as component (C), to thereby produce a composition and a cured product. Table 2 shows the evaluation results of the thus-produced cured product.

### Example 13

The procedure of Example 10 was repeated, except that 2-isocyanatoethyl methacrylate (Karenz MOI (trade name), product of Showa Denko K.K.) was employed as component (C), to thereby produce a composition and a cured product. Table 2 shows the evaluation results of the thus-produced cured product.

### Example 14

The procedure of Example 10 was repeated, except that 3-methacryloxypropyltrimethoxysilane (KBM-503 (trade name), product of Shin-Etsu Chemical Co., Ltd.) was employed as component (C), to thereby produce a composition and a cured product. Table 2 shows the evaluation results of the thus-produced cured product.

### Example 15

The procedure of Example 10 was repeated, except that tetrahydrofurfuryl methacrylate (SR203 (trade name), product of Sartomer) was employed as component (C), to thereby produce a composition and a cured product. Table 2 shows the evaluation results of the thus-produced cured product.

### Example 16

The procedure of Example 10 was repeated, except that KAYAMER PM-21 (trade name, product of Nippon Kayaku Co., Ltd., methacrylate having a phosphoric acid ester structure) (0.1 g) was employed as component (C), to thereby produce a composition and a cured product. Table 2 shows the evaluation results of the thus-produced cured product.

### Comparative Example 2

The procedure of Example 10 was repeated, except that component (C) was not employed, to thereby produce a composition and a cured product. Table 2 shows the evaluation results of the thus-produced cured product.

[Table 2]

**Table 2**

| | | Example | | | | | | | Comparative Example |
|---|---|---|---|---|---|---|---|---|---|
| | | 10 | 11 | 12 | 13 | 14 | 15 | 16 | 2 |
| Total light transmittance (%) | Initial | 88 | 88 | 90 | 89 | 87 | 88 | 87 | 90 |
| | After heating at 140°C for 100 hrs | 86 | 85 | 90 | 75 | 85 | 86 | 85 | 88 |
| Adhesion test Maximum point stress (MPa) | Polyamide resin | - | 0 | 1 | 0 | 0 | - | - | 0 |
| | Silver-plated metal plate | 2 | 2 | 3 | 3 | 2 | 2 | 1 | 1 |

### Industrial Applicability

According to the present invention, there is provided a composition which exhibits excellent transparency and heat resistance, and which provides a cured product exhibiting excellent adhesion to a base member surrounding the product (e.g., a resin serving as a reflective material, or a metallic frame). The composition of the present invention is suitably employed as a raw material of an encapsulating material for a light-emitting element or a photoreceptor in a photo-semiconductor device, or as a raw material for a lens, etc. used in the semiconductor field or the optical field.

## Claims

1. A composition **characterized by** comprising the following components (A) to (D):
(A) one or more (meth)acrylate compounds selected from among a (meth)acryl-modified silicone fluid, a long-chain alkyl (meth)acrylate, and a polyalkylene glycol (meth)acrylate having a number average molecular weight of 400 or more;
(B) a (meth)acrylate compound having an alicyclic hydrocarbon group which has six or more carbon atoms and which is bonded to the compound via an ester bond;
(C) (meth)acrylic acid or a (meth)acrylate compound having a polar group selected from among a hydroxyl group, an epoxy group, a glycidyl ether group, a tetrahydrofurfuryl group, an isocyanate group, a carboxyl group, an alkoxysilyl group, a phosphoric acid ester group, a lactone group, an oxetane group, and a tetrahydropyranyl group; and
(D) a radical polymerization initiator.

2. A composition according to claim 1, wherein component (A) is a long-chain alkyl (meth)acrylate selected from among (meth)acrylates each having an alkyl group having 12 or more carbon atoms, and/or a polyalkylene glycol (meth)acrylate having a number average molecular weight of 400 or more.

3. A composition according to claim 1 or 2, wherein component (A) is a long-chain alkyl (meth)acrylate selected from among hydrogenated polybutadiene di(meth)acrylates and hydrogenated polyisoprene di(meth)acrylates, and/or a polyethylene glycol di(meth)acrylate having a number average molecular weight of 400 or more.

4. A composition according to any of claims 1 to 3, wherein component (B) is a (meth)acrylate compound having one or more alicyclic hydrocarbon groups selected from among an adamantyl group, a norbornyl group, an isobornyl group, a dicyclopentanyl group, and a cyclohexyl group, the alicyclic hydrocarbon groups being bonded to the compound via an ester bond.

5. A composition according to any of claims 1 to 4, wherein the amounts of component (A), component (B), and component (C) are 10 to 90 mass%, 5 to 90 mass%, and 0.5 to 50 mass%, respectively, on the basis of the total amount of components (A), (B), and (C), and the amount of component (D) is 0.01 to 10 parts by mass on the basis of 100 parts by mass of the total amount of components (A), (B), and (C).

6. A cured product produced through curing of a composition as recited in any of claims 1 to 5.

7. An encapsulating material comprising a cured product as recited in claim 6.

8. An encapsulating material according to claim 7, which is employed for a photo-semiconductor or a photoreceptor.

9. A lens produced from a cured product as recited in claim 6.

10. A lens according to claim 9, which is employed in the semiconductor field or the optical field.

## Patentansprüche

1. Eine Zusammensetzung, **dadurch gekennzeichnet, dass** sie die folgenden Komponenten (A) bis (D) umfasst:
(A) eine oder mehrere (Meth)acrylatverbindungen, ausgewählt aus einem (Meth)acryl-modifizierten Silikonfluid, einem langkettigen Alkyl(meth)acrylat und einem Polyalkylenglycol(meth)acrylat mit einem Zahlenmittel des Molekulargewichts von 400 oder mehr;
(B) eine (Meth)acrylatverbindung mit einer alicyclischen Kohlenwasserstoffgruppe, welche sechs oder mehr Kohlenstoffatome aufweist und welche über eine Esterbindung an die Verbindung gebunden ist;
(C) (Meth)acrylsäure oder eine (Meth)acrylatverbindung mit einer polaren Gruppe, ausgewählt aus einer Hydroxylgruppe, einer Epoxygruppe, einer Glycidylethergruppe, einer Tetrahydrofurfurylgruppe, einer Isocyanatgruppe, einer Carboxylgruppe, einer Alkoxysilylgruppe, einer Phosphorsäureestergruppe, einer Lactongruppe, einer Oxetangruppe und einer Tetrahydropyranylgruppe; und
(D) einen radikalischen Polymerisationsinitiator.

2. Eine Zusammensetzung gemäß Anspruch 1, wobei Komponente (A) ein langkettiges Alkyl(meth)acrylat, ausgewählt aus (Meth)acrylaten mit jeweils einer Alkylgruppe mit 12 oder mehr Kohlenstoffatomen, und/oder ein Polyalkylenglycol(meth)acrylat mit einem Zahlenmittel des Molekulargewichts von 400 oder mehr, ist.

3. Eine Zusammensetzung gemäß Anspruch 1 oder 2, wobei Komponente (A) ein langkettiges Alkyl(meth)acrylat, ausgewählt aus hydrierten Polybutadiendi(meth)acrylaten und hydrierten Polyisoprendi(meth)acrylaten, und/oder ein Polyethylenglycol-di(meth)acrylat mit einem Zahlenmittel des Molekulargewichts von 400 oder mehr ist.

4. Eine Zusammensetzung gemäß einem der Ansprüche 1 bis 3, wobei Komponente (B) eine (Meth)acrylatverbindung mit einer oder mehreren alicyclischen Kohlenwasserstoffgruppen, ausgewählt aus einer Adamantylgruppe, einer Norbornylgruppe, einer Isobornylgruppe, einer Dicyclopentanylgruppe und einer Cyclohexylgruppe ist, wobei die alicyclischen Kohlenwasserstoffgruppen über eine Esterbindung an die Verbindung gebunden sind.

5. Eine Zusammensetzung gemäß einem der Ansprüche 1 bis 4, wobei die Mengen der Komponente (A), Komponente (B) und Komponente (C) 10 bis 90 Massen-%, 5 bis 90 Massen-% bzw. 0,5 bis 50 Massen-%, bezogen auf die Gesamtmenge der Komponenten (A), (B) und (C), betragen und die Menge der Komponente (D) 0,01 bis 10 Massenteile, bezogen auf 100 Massenteile der Gesamtmenge der Komponenten (A), (B) und (C), beträgt.

6. Ein gehärtetes Produkt, hergestellt durch Härten einer Zusammensetzung, gemäß einem der Ansprüche 1 bis 5.

7. Ein Verkapselungsmaterial, umfassend ein gehärtetes Produkt, gemäß Anspruch 6.

8. Ein Verkapselungsmaterial gemäß Anspruch 7, welches für einen Photohalbleiter oder einen Photorezeptor verwendet wird.

9. Eine Linse, hergestellt aus einem gehärteten Produkt, gemäß Anspruch 6.

10. Eine Linse gemäß Anspruch 9, welche im Halbleiterbereich oder optischen Bereich verwendet wird.

## Revendications

1. Composition, **caractérisée en ce qu'**elle comprend les composants (A) à (D) suivants :
(A) un ou plusieurs composés de (méth)acrylate choisis parmi un fluide de silicone modifié par un groupe (méth)acrylique, un (méth)acrylate d'alkyle à longue chaîne, et un (méth)acrylate de polyalkylène glycol ayant un poids moléculaire moyen en nombre de 400 ou plus ;
(B) un composé de (méth)acrylate ayant un groupe hydrocarboné alicyclique qui possède six atomes de carbone ou plus, et qui est lié au composé par le biais d'une liaison ester ;
(C) de l'acide (méth)acrylique ou un composé de (méth)acrylate ayant un groupe polaire choisi parmi un groupe hydroxyle, un groupe époxy, un groupe éther de glycidyle, un groupe tétrahydrofurfuryle, un groupe isocyanate, un groupe carboxyle, un groupe alcoxysilyle, un groupe ester d'acide phosphorique, un groupe lactone, un groupe oxétane, et un groupe tétrahydropyranyle ; et
(D) un initiateur de polymérisation radicalaire.

2. Composition selon la revendication 1, dans laquelle le composant (A) est un (méth)acrylate d'alkyle à longue chaîne choisi parmi les (méth)acrylates ayant chacun un groupe alkyle de 12 atomes de carbone ou plus, et/ou un (méth)acrylate de polyalkylène glycol ayant un poids moléculaire moyen en nombre de 400 ou plus.

3. Composition selon la revendication 1 ou 2, dans laquelle le composant (A) est un (méth)acrylate d'alkyle à longue chaîne choisi parmi les di(méth)acrylates de polybutadiène hydrogénés et les di(méth)acrylates de polyisoprène hydrogénés, et/ou un di(méth)acrylate de polyéthylène glycol ayant un poids moléculaire moyen en nombre de 400 ou plus.

4. Composition selon l'une quelconque des revendications 1 à 3, dans laquelle le composant (B) est un composé de (méth)acrylate ayant un ou plusieurs groupes hydrocarbonés alicycliques choisis parmi un groupe adamantyle, un groupe norbornyle, un groupe isobornyle, un groupe dicyclopentanyle, et un groupe cyclohexyle, les groupes hydrocarbonés alicycliques étant liés au composé par le biais d'une liaison ester.

5. Composition selon l'une quelconque des revendications 1 à 4, dans laquelle les quantités du composant (A), du composant (B), et du composant (C) sont de 10 à 90 % en poids, 5 à 90 % en poids, et 0,5 à 50 % en poids, respectivement, sur la base de la quantité totale des composants (A), (B) et (C), et la quantité du composant (D) est de 0,01 à 10 parties en poids sur la base de 100 parties en poids de la quantité totale des composants (A), (B) et (C).

6. Produit durci obtenu par durcissement d'une composition telle que définie selon l'une quelconque des revendications 1 à 5.

7. Matériau encapsulant comprenant un produit durci tel que défini selon la revendication 6.

8. Matériau encapsulant selon la revendication 7, qui est utilisée pour un photo-semi-conducteur ou un photorécepteur.

9. Lentille produite à partir d'un produit durci tel que défini selon la revendication 6.

10. Lentille selon la revendication 9, qui est utilisée dans le domaine des semiconducteurs ou le domaine optique.
